# EUROPÄISCHE PATENTSCHRIFT

(11) **EP 0 840 660 B1**
(45) Veröffentlichungstag und Bekanntmachung des Hinweises auf die Patenterteilung: **12.05.1999**
(21) Anmeldenummer: 96924740.2
(22) Anmeldetag: 18.07.1996
(51) Int. Cl.: B23K 1/20, H01L 23/498

(54) **FLUSSMITTELFREIE KONTAKTIERUNG VON BAUELEMENTEN**
FLUXLESS CONTACTING OF COMPONENTS
MISE EN CONTACT SANS FONDANT DE COMPOSANTS

(30) Priorität: 25.07.1995 DE 19527172; 17.07.1996 DE 19628702
(43) Veröffentlichungstag der Anmeldung: 13.05.1998
(73) Patentinhaber: Zakel, Elke, 14612 Falkensee (DE)
(72) Erfinder: KLOESER, Joachim, D-12059 Berlin (DE); ZAKEL, Elke, D-12163 Berlin (DE); REICHL, Herbert, D-14193 Berlin (DE)
(74) Vertreter: Böck, Bernhard, Dipl.-Ing.
(86) Internationale Anmeldenummer: DE9601298
(87) Internationale Veröffentlichungsnummer: WO9704910

(56) Entgegenhaltungen:
- EP-A- 0 341 465
- US-A- 3 663 184
- PROCEEDINGS OF THE IEEE/CPMT INTERNATIONAL ELECTRONICS MANUFACTURING TECHNOLOGY SYMPOSIUM, LA JOLLA, SEPT. 12 - 14, 1994, Bd. VOL. 1, Nr. SYMP. 16, 12.September 1994, INSTITUTE OF ELECTRICAL AND ELECTRONICS ENGINEERS, Seiten 177-184, XP000530089 ZAKEL E ET AL: "FLUXLESS FLiP CHIP ASSEMBLY ON RIGID AND FLEXIBLE POLYMER SUBSTRATES USING THE AU-SN METALLURGY"
- PATENT ABSTRACTS OF JAPAN vol. 018, no. 545 (E-1617), 18.Oktober 1994 & JP,A,06 196486 (NEC CORP), 15.Juli 1994,
- 9TH EUROPEAN HYBRID MICROELECTRONICS CONFERENCE, 2. - 4.Juni 1993, NICE, FRANCE, Seiten 339-350, XP000607647 ZAKEL ET AL: "Flip-chip bonding on green tape ceramic substrates"
- 1995 PROCEEDINGS 45TH ELECTRONIC COMPONENTS & TECHNOLOGY CONFERENCE, 21. - 24.Mai 1995, LAS VEGAS, NEVADA, Seiten 1179-1190, XP000607536 KLOESER ET AL: "Reliability investigations of fluxless flip-chip interconnections on green tape ceramic substrates"

## Beschreibung

Die Erfindung betrifft ein Verfahren zur flußmittelfreien Kontaktierung von Bauelementen auf einem Substrat gemaß dem Oberbegriff des Anspruchs 1.

Flußmittel werden bei der Herstellung von Lotverbindungen zwischen Anschlußflächen eines Bauelements und zugeordneten Anschlußflächen eines Substrats verwendet, da sie grundsätzlich die Benetzungsfähigkeit von metallischen Oberflächen mit dem schmelzflüssigen Lotmaterial verbessern. Darüber hinaus werden durch die Verwendung von Flußmitteln vorhandene Oxyde und andere benetzungshemmende Deckschichten oder Partikel aufgelöst oder von den Anschlußflächen weggeschwemmt Schließlich wird durch die reduzierende Wirkung der Flußmittel die Oxydation der erhitzten metallischen Oberflachen bei der Kontaktierung verhindert. Als besonders wichtig erweist sich die Verwendung von Flußmitteln bei den insbesondere in der Flip-Chip-Technologie regelmäßig verwendeten hochschmelzenden Blei/Zinn-Legierungsmaterialien mit hohem Bleianteil.

Diesen, als positiv zu bezeichnenden Eigenschaften der Flußmittel steht andererseits die negative Eigenschaft gegenüber, daß durch im Verbindungsbereich verbleibende Flußmittelrückstande eine spätere Korrosion der metallischen Verbindungen zwischen den Bauelementen und dem Substrat die Folge ist Diese, durch die Flußmittelreste gebildeten Korrosionsherde beeinträchtigen erheblich Zuverlässigkeit und Lebensdauer von elektronischen Komponenten, die aus Bauelementen und Substraten zusammengesetzt sind. Bei derartigen Komponenten kann es sich beispielsweise um ein Chipmodul, also einen auf einem Trägersubstrat kontaktierten Chip, handeln. Abgesehen von ihrer Wirkung als Korrosionsherde können auch die Flußmittelreste als solche zu unerwünschten Beeinträchtigungen führen. So kann es beispielsweise bei optischen Bauelementen zu unerwünschten Trübungseffekten kommen.

Um den vorbeschriebenen, nachteiligen, durch Flußmittelruckstände bewirkten Korrosionseffekt zu verhindern oder zumindest einzuschränken, ist man bei Bauelement/Substrat-Komponenten, an deren Funktionssicherheit besonders hohe Anforderungen gestellt werden dazu übergegangen, der Kontaktierung eine Reinigung der Kontaktbereiche von Flußmittelrückständen nachzuordnen oder stattdessen auf die Verwendung von Flußmitteln zu verzichten und die Kontaktierung unter Schutzgas, beispielsweise Formiergas, durchzuführen. Die letztere Verfahrensweise erfordert zwar einen entsprechend hohen apparativen Aufwand. Andererseits hat sich jedoch herausgestellt, daß eine alternative, der Kontaktierung nachfolgende Reinigung der Kontaktbereiche von Flußmittelrückständen schon allein wegen der erschwerten Zugänglichkeit der Kontaktbereiche nur sehr aufwendig und selten vollständig durchführbar ist Aufgrund der miniaturisierten Abmessungen ergeben sich auch entsprechend geringe Spaltweiten zwischen dem Bauelement und dem Substrat, die nicht nur die Reinigung selbst, sondern schon auch eine optische Inspektion der Kontaktbereiche auf das Vorliegen von Flußmittelrückständen nahezu unmöglich macht.

Die vorstehenden Überlegungen spielen insbesondere in der sogenannten 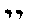 Flip-Chip-Technologie" eine wesentliche Rolle, da es hier schon aufgrund der geringen Größenabmessungen eines Chips zur Ausbildung entsprechend geringer Spaltweiten zwischen dem Chip und dem Substrat nach der Kontaktierung kommt, so daß eine Reinigung mit einem für eine Großserienfertigung vertretbaren Aufwand nicht mehr möglich, da unwirtschaftlich ist.

Aus der US-A-3,663,184 ist ein Verfahren zur Kontaktierung von Bauelementen auf einem Substrat bekannt, bei dem aus einem flußmittelbeaufschlagten Gold/Zinn-Lotmaterial auf Anschlußflächen erhöhte Kontaktmetallisierungen erzeugt werden und dabei an der Oberfläche des Bauelements entstehende Flußmittelrückstände vor dem Aufschmelzen der erhöhten Kontaktmetallisierungen zur Kontaktierung mit Anschlußflächen des Substrats entfernt werden.

Aus 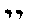 Proceedings of the IEEE/CPMT International Electronics Manufacturing Technology Symposium", La Jolla, Sept. 12-14, 1994, Vol. 1, Nr. Symp. 16, 12. September 1994, Institute of Electrical and Electronics Engineers, Seiten 177-184, ist ein Verfahren zur Kontaktierung von Bauelementen auf einem Substrat bekannt, bei dem ein Gold/Zinn-Lotmaterial für die Herstellung der erhöhten Kontaktmetallisierungen und die Kontaktierung ohne Verwendung von Flußmittel vorgeschlagen wird.

Der vorliegenden Erfindung liegt die Aufgabe zugrunde, ein verbessertes Verfahren zur flußmittelfreien Kontaktierung von Bauelementen auf einem Substrat ausgehend von der Verwendung von flußmittelbeaufschlagtem Gold/Zinn-Material zur Herstellung der erhöhten Kontaktmetallisierungen vorzuschlagen.

Diese Aufgabe wird durch ein Verfahren mit den Merkmalen des Anspruchs 1 gelöst.

Bei dem erfindungsgemäßen, durch den Gegenstand des Anspruchs 1 definierten Verfahren wird dies dadurch erreicht, daß die Ausbildung der erhöhten Kontaktmetallisierungen durch ein Umschmelzen des Lotmaterialauftrags erfolgt, derart, daß im Lotmaterial enthaltene Flußmittelzuschläge an der Oberfläche der Kontaktmetallisierung ausgeschieden werden.

Hierdurch ist es möglich, auch die nach Aufbringen des Lotmaterialauftrags im Lotmaterial noch enthaltenen Flußmittelzuschläge an der Oberfläche der Kontaktmetallisierung als Flußmittelanlagerung auszuscheiden und anschließend zu entfernen, so daß die anfänglich im Lotmaterial enthaltenen Flußmittel nach dem Aufschmelzen der Bumps zur Herstellung der Kontaktierung nicht mehr für eine erneute Verunreinigung der Kontaktbereiche sorgen können.

Sowohl bei der vorstehenden, als vorteilhaft beschriebenen Ausführungsform, wie auch bei Durchführung des Verfahrens gemäß dem Anspruch 1 ist es möglich, in der Zuordnung der Kontaktmetallisierungen zu den Anschlußflächen des Bauelements oder des Substrats zu wählen, also die Kontaktmetallisierung nicht nur auf den Anschlußflächen des Bauelements, sondern auch alternativ auf den Anschlußflächen des Substrats auszubilden.

Als besonders vorteilhaft - da hinsichtlich der Durchführung des Reinigungsverfahrens besonders ökonomisch - erweist es sich, wenn sich während der Erzeugung der erhöhten Kontaktmetallisierungen und der nachfolgenden Entfernung der Flußmittelrückstände die Bauelemente in einem Verbund einer Vielzahl von Bauelementen befinden und erst nach der Entfernung der Flußmittelrückstände, also der Reinigung, die Vereinzelung der Bauelemente erfolgt.

Wenn es sich bei den Bauelementen um Chips handelt, kann die Erzeugung der erhöhten Kontaktmetallisierungen und die nachfolgende Entfernung der Flußmittelrückstände auf Waferebene, also vor dem Vereinzeln der Chips aus dem Wafer, beispielsweise durch Sägen, erfolgen.

Für den Fall, daß die Ausbildung der erhöhten Kontaktmetallisierungen auf Aluminium-Anschlußflächen erfolgen soll, erweist es sich als vorteilhaft, wenn vor dem Auftrag des Gold/Zinn-Lotmaterials die Ausbildung einer Nickel-Zwischenschicht auf den Anschlußflächen erfolgt. Hierdurch wird ein Flußmittelkontakt für die besonders korrosionsanfälligen Aluminium-Anschlußflächen beim Auftrag des flußmittelbeaufschlagten Lotmaterials wirksam verhindert. Die Nickelschicht bildet eine quasi hermetische Abschirmung der Aluminiumoberflächen

Als besonders vorteilhaft erweist es sich, wenn die Ausbildung der Nickel-Zwischenschicht auf den Aluminium-Anschlußflächen durch autokatalytische Abscheidung erfolgt. Hierdurch wird eine einfache Nickelbeschichtung der Aluminium-Anschlußflächen, beispielsweise durch Ablagerung von Nickelsedimenten auf den in einem Nickelbad angeordneten Anschlußflächen, möglich

Nachfolgend wird das Verfahren anhand eines Ausführungsbeispiels unter Bezugnahme auf die Zeichnungen näher erläutert. Es zeigen
**Fig. 1** eine schematische Darstellung eines Wafers mit im Waferverbund angeordneten Chips;
**Fig. 2** eine Teilschnittdarstellung eines Chips gemäß Schnittlinienverlauf II - II in **Fig. 1**;
**Fig. 3** die in **Fig. 2** dargestellte Anschlußfläche mit einer darauf angeordneten Nickel-Zwischenschicht;
**Fig. 4** die in **Fig. 3** dargestellte Nickel-Zwischenschicht mit einem Lotmaterialauftrag;
**Fig. 5** der in **Fig. 4** dargestellte, zu einer erhöhten Kontaktmetallisierung umgeschmolzene Lotmaterialauftrag mit Flußmittelresten;
**Fig. 6** die in **Fig. 5** dargestellte erhöhte Kontaktmetallisierung nach der Reinigung von Flußmittelresten;
**Fig. 7** die Kontaktierung der Chip-Anschlußfläche mit einer Substratanschlußfläche;
**Fig. 8** eine erfolgte Lotmaterialverbindung zwischen einer Chipanschlußfläche und der Substratanschlußfläche;

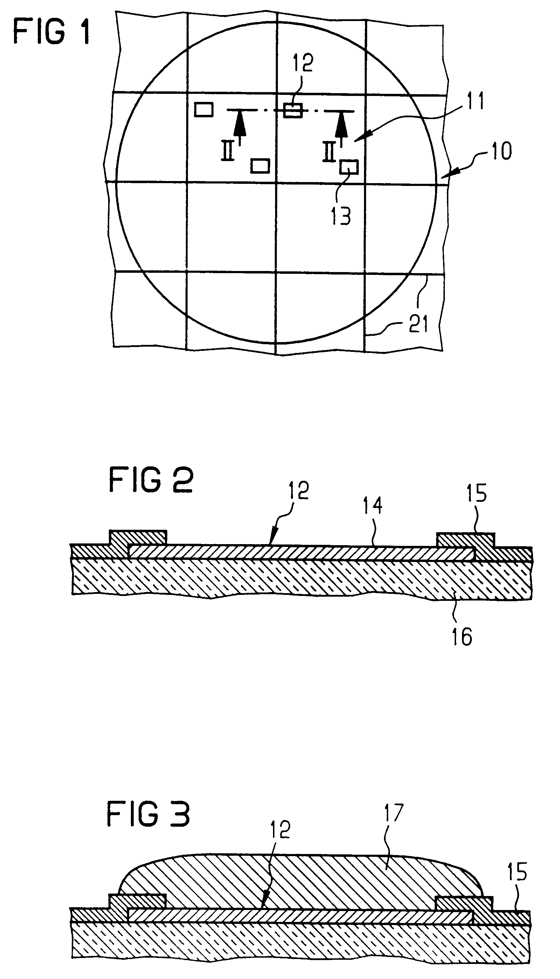

**Fig. 1** zeigt die schematische Darstellung der Oberfläche eines Wafers 10 mit einer Vielzahl von zusammenhängend im Waferverbund angeordneten Chips 11, die jeweils mehrere Anschlußflächen 12, 13 aufweisen, von denen hier aus Gründen der vereinfachten Darstellung lediglich zwei dargestellt sind.

**Fig. 2** zeigt eine Teilschnittdarstellung eines Chips 11 im Bereich einer Anschlußfläche 12. Die Anschlußfläche 12 ist durch die frei zugängliche Oberfläche eines flächigen Aluminiumleiters 14 auf der ansonsten durch eine Passivierung 15 abgedeckten Oberfläche eines Siliziumkörpers 16 des Chips 11 bzw. des Wafers 10 gebildet.

**Fig. 3** zeigt den Zustand der Anschlußfläche 12 nach einer ersten Phase einer hier im folgenden beispielhaft dargestellten Variante des Verfahrens zur flußmittelfreien Kontaktierung von Bauelementen, in der eine Nickel-Zwischenschicht 17 auf der Anschlußfläche 12 autokatalytisch abgeschieden wird.

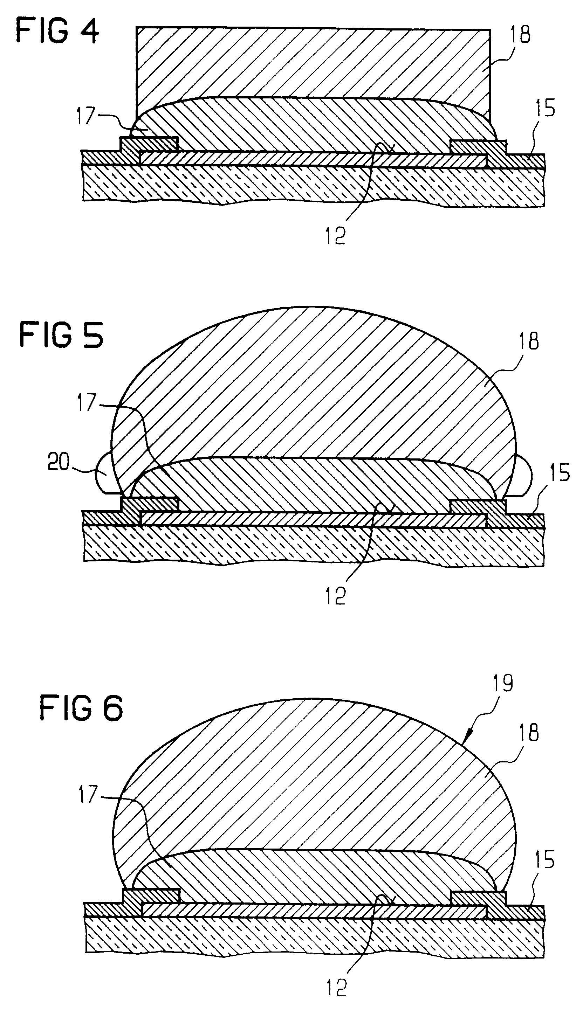

**Fig. 4** zeigt den Zustand der Anschlußfläche 12 nach einer weiteren Phase des Verfahrens, in der, hier beispielsweise über ein Schablonenauftragsverfahren, eine definierte Menge eines als Lotpaste ausgebildeten Lotmaterials 18 auf die Nickel-Zwischenschicht 17 aufgebracht wird. Im pastenförmigen Lotmaterial 18 sind hier nicht näher dargestellte Flußmittelzuschläge enthalten Ansonsten weist das Lotmaterial 18 zumindest einen erheblichen Anteil einer Gold/Zinn-Legierung auf. Die Menge der Flußmittelzugaben richtet sich je nach der die Benetzungseigenschaften wesentlich mitbestimmenden Lotmaterialzusammensetzung.

**Fig. 5** zeigt den Zustand der Anschlußfläche 12 nach einem Umschmelzen des Lotmaterials 18 zur Ausbildung einer erhöhten Kontaktmetallisierung 19, die fachsprachlich auch als sogenannter 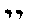 Bump" bezeichnet wird. Wie aus **Fig. 5** zu ersehen ist, werden bedingt durch das Umschmelzverfahren die im Lotmaterial 18 enthaltenden Flußmittelzuschläge an der Oberfläche der Kontaktmetallisierung 19 als Flußmittelanlagerung 20 ausgeschieden.

**Fig. 6** zeigt den Zustand der Kontaktmetallisierung 19 nach erfolgter Reinigung von der Flußmittelanlagerung 20, wobei diese Reinigung zu einem Zeitpunkt erfolgt, zu dem sich die in **Fig. 1** dargestellten Chips 11 noch immer im Waferverbund befinden, also der Wafer 10 noch in seiner Gesamtheit besteht. Erst danach erfolgt eine, in der **Fig. 1** durch die eingezeichneten Trennlinien 21 angedeutete Vereinzelung der Chips 11 und somit die Auflösung des Waferverbunds

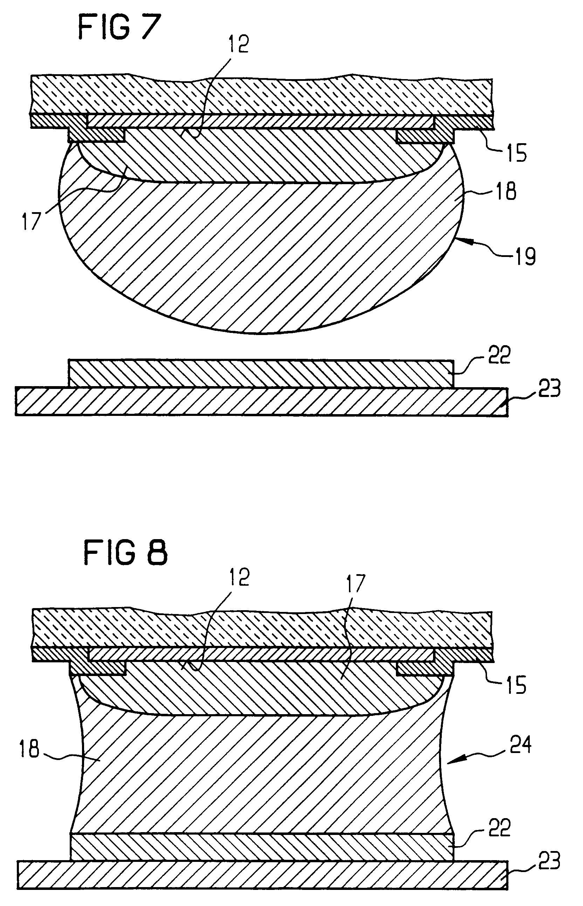

Nach der Vereinzelung erfolgt, wie in **Fig. 7** am Beispiel einer Paarung der Anschlußfläche 12 des Chips 11 mit einer Anschlußfläche 22 eines Substrats 23 dargestellt, eine Kontaktierung zwischen der aufgeschmolzenen Kontaktmetallisierung 19 und der Anschlußfläche 22 des Substrats 23 Hierzu wird entsprechend der Flip-Chip-Technologie der Chip 11 von oben auf das Substrat 23 abgesenkt.

Schließlich zeigt **Fig. 8** eine fertiggestellte Lotverbindung 24 zwischen der Anschlußfläche 12 des Chips 11 und der Anschlußfläche 22 des Substrats 23 mit der für dieses Kontaktierverfahren typischen, durch die Oberflächenspannung der aufgeschmolzenen Kontaktmetallisierung 19 bedingten parabolischen Einschnürung

## Patentansprüche

1. Verfahren zur flußmittelfreien Kontaktierung von Bauelementen auf einem Substrat, bei dem zunächst Anschlußflächen des Bauelements oder des Substrats mit einem Lotmaterialauftrag aus einem flußmittelbeaufschlagten Gold/Zinn-Lotmaterial zur Ausbildung erhöhter Kontaktmetallisierungen versehen werden und anschließend zur Kontaktierung der Kontaktmetallisierungen mit Anschlußflächen des Substrats ein Aufschmelzen der Kontaktmetallisierungen nach einer Entfernung von auf der Oberfläche des Bauelements angeordneten Flußmittelrückständen erfolgt,
dadurch **gekennzeichnet,**
daß die Ausbildung der erhöhten Kontaktmetallisierungen (19) durch ein Umschmelzen des Lotmaterialauftrags (18) erfolgt, derart, daß im Lotmaterial enthaltene Flußmittelzuschläge (20) an der Oberfläche der Kontaktmetallisierung (19) ausgeschieden werden.

2. Verfahren nach Anspruch 1,
dadurch **gekennzeichnet,**
daß sich während der Erzeugung der erhöhten Kontaktmetallisierungen (19) und der nachfolgenden Entfernung der Flußmittelrückstände (20) eine Mehrzahl von Bauelementen (11) in einem Verbund (10) befinden und erst anschließend eine Vereinzelung der Bauelemente (11) erfolgt.

3. Verfahren nach Anspruch 2,
dadurch **gekennzeichnet,**
daß es sich bei den Bauelementen um Chips (11) handelt, die vor der Vereinzelung Bestandteile eines Wafers (10) sind.

4. Verfahren nach einem oder mehreren der vorangehenden Ansprüche,
dadurch **gekennzeichnet,**
daß im Falle von Aluminium-Anschlußflächen (12) vor dem Auftrag des Gold/Zinn-Lotmaterials (18) die Ausbildung einer Nickel-Zwischenschicht (17) auf den Anschlußflächen (12) erfolgt.

5. Verfahren nach Anspruch 4,
dadurch **gekennzeichnet,**
daß die Ausbildung der Nickel-Zwischenschicht (17) auf den Aluminium-Anschlußflächen (12) durch autokatalytische Abscheidung erfolgt.

## Claims

1. Process for fluxless contacting of elements on a substrate, wherein firstly, with a view to forming raised contact metallisations, terminal areas of the element or of the substrate are provided with a deposit of solder material consisting of a-gold/tin solder material to which flux has been added and, subsequently, with a view to contacting the contact metallisations with terminal areas of the substrate, fusing of the contact metallisations is effected after removal of flux residues disposed on the surface of the element,
characterised in that
the raised contact metallisations (19) are formed by remelting the deposit of solder material (18) in such a way that flux supplements (20) contained in the solder material are deposited on the surface of the contact metallisation (19).

2. Process according to Claim 1,
characterised in that
during the generation of the raised contact metallisations (19) and the subsequent removal of the flux residues (20) a plurality of elements (11) are located in a composite (10) and separation of the elements (11) is only effected subsequently.

3. Process according to Claim 2,
characterised in that
the elements are chips (11) which prior to separation are constituents of a wafer (10).

4. Process according to one or more of the preceding claims,
characterised in that
in the case of aluminium terminal areas (12) a nickel interlayer (17) is formed on the terminal areas (12) prior to application of the gold/tin solder material (18).

5. Process according to Claim 4,
characterised in that
the nickel interlayer (17) is formed on the aluminium terminal areas (12) by autocatalytic deposition.

## Revendications

1. Procédé pour la mise en contact, sans fondant, de composants sur un substrat, selon lequel on applique tout d'abord à des surfaces de raccordement du composant ou du substrat un dépôt de brasure formé d'une brasure à base d'or / étain chargée par un fondant pour la formation de métallisations de contact surélevées, puis, pour l'établissement du contact des métallisations de contact avec des surfaces de contact du substrat, on exécute une fusion des métallisations de contact après élimination de résidus de fondant disposés sur la surface du composant, caractérisé en ce
que la formation des métallisations surélevées de contact (19) est exécutée au moyen d'une refusion du dépôt de brasure (18) de telle sorte que des additifs de fondant (20) contenus dans la brasure se déposent sur la surface de la métallisation de contact (19).

2. Procédé selon la revendication 1, caractérisé en ce
que pendant la formation des métallisations surélevées de contact (19) et l'élimination ultérieure des résidus de fondants (20), une pluralité de composants (11) forment un ensemble combiné (10) et on exécute ensuite seulement une séparation des composants (11).

3. Procédé selon la revendication 2, caractérisé en ce
qu'en ce qui concerne les composants, il s'agit de plaquettes (11), qui sont les composants d'une pastille (10) avant l'individualisation des composants.

4. Procédé selon une ou plusieurs des revendications précédentes, caractérisé en ce
que dans le cas de surfaces de raccordement en aluminium (12), avant le dépôt de la brasure à base d'or / étain (18), on forme une couche intercalaire de nickel (17) sur les surfaces de raccordement (12).

5. Procédé selon la revendication 4, caractérisé en ce
que la formation de la couche intercalaire de nickel (17) sur les surfaces de raccordement en aluminium (12) s'effectue au moyen d'un dépôt autocatalytique.
